# EUROPÄISCHE PATENTSCHRIFT

(11) **EP 4 196 804 B1**
(45) Veröffentlichungstag und Bekanntmachung des Hinweises auf die Patenterteilung: **16.04.2025**
(21) Anmeldenummer: 21703825.6
(22) Anmeldetag: 27.01.2021
(51) Int. Cl.: G01R 31/311, G01R 1/07, G01R 1/04

(54) **KONTAKTIERUNGSMODUL ZUR KONTAKTIERUNG OPTO-ELEKTRONISCHER CHIPS**
CONTACTING MODULE FOR CONTACTING OPTOELECTRONIC CHIPS
MODULE DE MISE EN CONTACT POUR LA MISE EN CONTACT DE PUCES OPTOÉLECTRONIQUES

(30) Priorität: 14.08.2020 DE 102020005065
(43) Veröffentlichungstag der Anmeldung: 21.06.2023
(73) Patentinhaber: JENOPTIK Optical Systems GmbH, 07745 Jena (DE)
(72) Erfinder: BÜTTNER, Robert, 07749 Jena (DE); GRUNDMANN, Armin, 07743 Jena (DE); GNAUSCH, Tobias, 07743 Jena (DE); KADEN, Thomas, 01099 Dresden (DE); FRANZ, Stefan, 07751 Jena (DE); KARRAS, Christian, 07743 Jena (DE)
(74) Vertreter: Gleim Petri Patent- und Rechtsanwaltspartnerschaft mbB
(86) Internationale Anmeldenummer: PCT/DE2021/100079
(87) Internationale Veröffentlichungsnummer: WO 2022/033618

(56) Entgegenhaltungen:
- WO-A1-2019/029765
- CN-A- 111 123 072
- DE-A1- 102012 008 144
- US-A- 5 631 571
- US-A1- 2001 028 254
- US-A1- 2005 179 427
- US-A1- 2012 033 208
- US-A1- 2017 315 299
- US-B1- 6 515 494

## Beschreibung

Die Erfindung betrifft ein Kontaktierungsmodul zum Testen von opto-elektronischen Chips, wie es gattungsgemäß aus der WO 2019/029765 A1 bekannt ist.

Die Erfindung ist im Bereich des Testens und Qualifizierens von Chips mit optischelektrisch integrierten Schaltungen, sogenannten PICs (Photonic Integrated Circuits), auf Wafer-Ebene angesiedelt. Im Unterschied zu herkömmlichen Chips mit rein elektrisch integrierten Schaltungen, sogenannten ICs (Integrated Circuits), sind bei PICs neben den elektrischen Schaltungen auch optische Funktionalitäten integriert.

Bei der Herstellung von ICs, z. B. mittels CMOS-Technologie, finden in verschiedenen Herstellungsschritten Tests und Messungen statt, um einerseits den Prozess zu überwachen und andererseits eine Qualitätskontrolle durchzuführen. Ein etablierter Test ist dabei der elektrische Wafer Level Test nach der Fertigstellung des Wafers. Hier werden funktionale und nicht-funktionale Chips (Known Good Dies) ermittelt, in einer Wafermap erfasst und damit die Ausbeute bestimmt. Beim Vereinzeln des Wafers in einzelne Chips erfolgt dann das Aussortieren der nicht funktionalen Chips. Die für den Wafer Level Test benötigte Testapparatur steht in Form von Waferprobern und Wafertestern mit zugehörigen Kontaktierungsmodulen (Probecards) zur Verfügung. Mittels des Kontaktierungsmoduls werden die geräteseitigen Schnittstellen (Ein- und Ausgänge) des Wafertesters mit den individuellen Schnittstellen (Ein- und Ausgänge) der Chips des auf dem Waferprober fixierten Wafers verbunden. Das Kontaktierungsmodul ist in der Regel so ausgeführt, dass es nur einen Chip kontaktiert, kann aber auch zur gleichzeitigen Kontaktierung mehrerer Chips ausgeführt sein. Es ist auch nicht zwingend erforderlich, dass die Chips zur Kontaktierung noch im Waferverbund vorliegen. Um gleichzeitig mehrere oder auch nacheinander die Chips eines Wafers zu kontaktieren, müssen die Chips lediglich eine fixierte und definierte Lage zueinander aufweisen. Dieser Spielraum ist für Kontaktierungsmodule des Standes der Technik ebenso gegeben wie für ein erfindungsgemäßes Kontaktierungsmodul.

Testapparaturen zum Testen rein elektronischer Chips (Halbleiterchip mit ICs) wurden über Jahrzehnte optimiert und diversifiziert, um zur Kostenoptimierung hohe Volumina unterschiedlichster ICs mit hohem Durchsatz qualifizieren zu können.

Die Herstellung der PICs erfolgt i.d.R. mit den gleichen etablierten Halbleiterprozessen, z. B. der CMOS-Technologie. Die bisher im Vergleich zur IC-Herstellung sehr geringen Fertigungsvolumina von PICs führten anfänglich dazu, dass i.d.R. in einer Halbleiterfabrik nur Tests zur Prozesscharakterisierung, aber keine funktionalen Tests der PICs durchgeführt wurden. Die funktionale Charakterisierung oblag dem Endkunden und wurde oft an gesägten Chips durchgeführt. Für die benutzte Testapparatur wurden voneinander unabhängige, getrennte elektrische und optische Kontaktierungsmodule verwendet,

Das Testen von PICs auf Wafer-Level-Ebene erfordert das Ein- und Auskoppeln von Licht aus der Ebene der PICs heraus, i.d.R. mittels integrierter Grating-Koppler als Koppelstellen. Die Grating-Koppler können funktionaler Bestandteil im Chip oder Opferstrukturen auf dem Wafer z. B. im Ritzgraben oder auf benachbarten Chips sein.

Aus der US 6 515 494 B1 ist eine Vorrichtung zum Testen elektronischer Chips bekannt, die ein Infrarotmikroskop zum Abbilden und Justieren der Nadelspitzen eines Kontaktierungsmoduls zu den Pads des elektronischen Chips beinhaltet.

Aus der vorgenannten US 2006/0109015 A1 ist ein opto-elektronisches Kontaktierungsmodul (probe module) zum Testen von Chips mit elektrischen und optischen Ein- und Ausgängen (zu untersuchendes Objekt - DUT) bekannt, enthaltend eine Kontaktierungsplatte (probe substrate) und eine Umverteilungsplatte (redistribution substrate). Das Kontaktierungsmodul stellt eine Schnittstelle zwischen einer Testapparatur (ATE) und dem DUT dar und ist mit elektrischen Kontakten (electical probes), optischen Kontakten (optical probes), optischen Elementen und Kombinationen hiervon ausgeführt, um Signale von dem DUT und zu dem DUT zu leiten und diese Signale umzuverteilen für eine Schnittstelle zur Testapparatur.

Die Auftrennung in eine Kontaktierungsplatte und eine Umverteilungsplatte führt zu einem modularen Design des Kontaktierungsmoduls, woraus sich der Vorteil ergibt, dass im Falle der Beschädigung der elektrischen Kontakte die Kontaktierungsplatte ersetzt werden kann, während die Umverteilungsplatte mit dem vergleichsweise teuren elektrischen und optischen Verteilernetz weiter benutzt werden kann.

Zu den optischen Ein- und Ausgängen (optische Schnittstellen) ist offenbart, dass diese über optische Elemente geschaffen sind, die sich auf der Kontaktierungsplatte und / oder der Umverteilungsplatte befinden und auf verschiedene Einkoppelmechanismen, z. B. Freistrahlung, Quasifreistrahlung oder Wellenleiter, abgestimmt sind. Als hierfür geeignete optische Elemente sind diffraktive Elemente und refraktive Elemente angegeben. Auch ist angegeben, dass ein Photodetektor oder eine Lichtquelle direkt an der Schnittstelle zum DUT angeordnet sein können, die dann den optischen Ein- oder Ausgang an der Kontaktierungsplatte darstellen.

Nach einem Ausführungsbeispiel der vorgenannten US 2006/0109015 A1 sind die optischen und die elektrischen Signalleitungen (optisches und elektrisches Verteilernetz) auf separaten Umverteilungsplatten ausgeführt. Es wird vorgeschlagen, die elektrischen Signale von dem DUT zu den Randbereichen der Kontaktierungsplatte zu führen, so dass in der oberhalb der Kontaktierungsplatte angeordneten ersten Umverteilungsplatte die elektrischen Signale oberhalb des Randbereiches eingekoppelt werden. Dadurch kann in der ersten Umverteilungsplatte, in der nur die elektrischen Signale umverteilt werden, eine Öffnung ausgebildet sein, durch die hindurch die optischen Signale in eine darüber angeordnete separate zweite Umverteilungsplatte geführt werden.

Zusammenfassend werden in der vorgenannten US 2006/0109015 A1 eine Vielzahl von Ideen aufgezeigt, wie ein Kontaktierungsmodul, das begründet, z. B. durch den Verschleiß der mechanischen Kontakte für die elektrische Signalübertragung, in eine Kontaktierungsplatte und eine Umverteilungsplatte unterteilt ist, zusätzlich mit optischen Signalleitungen ausgestattet werden könnte. Dabei wird außer Betracht gelassen, dass die für den mechanischen Kontakt der elektrischen Ein- und Ausgänge des Kontaktierungsmoduls zum DUT möglichen Toleranzen nicht auf die optischen Ein- und Ausgänge übertragbar sind.

Während die Übertragung eines stets gleichen elektrischen Signals über elektrische Schnittstellen den mechanischen Kontakt von an dem Kontaktierungsmodul vorhandenen Nadeln mit an dem DUT vorhandenen Kontaktplättchen (Kontaktpads) erfordert, was innerhalb einer vergleichsweise großen Lagetoleranz von einigen µm in alle drei Raumrichtungen gesichert werden kann, wird die Qualität der optischen Signalübertragung bereits bei einer sehr viel kleineren, im Sub-µm-Bereich liegenden Abweichung der optischen Schnittstellen von ihrer Solllage beeinflusst.

Aus der US 2012/0033208 A1 ist eine Vorrichtung zum Testen opto-elektronischer Chips bekannt, die über ein Optikmodul mit vier Optikblöcken verfügt, die jeweils in einer optischen Schnittstellenebene eine Anordnung von optischen Schnittstellen aufweisen. Das Optikmodul weist zudem eine Montageplatte auf. Die Vorrichtung verfügt außerdem über ein Elektronikmodul, enthaltend eine Trägerplatte, eine Leiterplatte und einen Nadelträger mit einer Anordnung von Kontaktierungsnadeln mit Nadelspitzen. Es besteht eine durch eine Federeinrichtung ausgeführte wiederholt lösbare Verbindung zwischen Montageplatte und Elektronikmodul. Die Vorrichtung weist keine permanente Verbindung zwischen den Optikblöcken und der Montageplatte auf, vielmehr wird der Optikblock auf der Montageplatte zu den optischen Schnittstellen des opto-elektronischen Chips justiert.

Aus der WO 2019/029765 A1 ist ein gegenüber Lagetoleranzen der optischen Schnittstellen unempfindliches Kontaktierungsmodul bekannt. Gleich einem erfindungsgemäßen und anderen aus dem Stand der Technik bekannten Kontaktierungsmodulen, ist ein hier beschriebenes Kontaktierungsmodul zwischen einer Waferplattform, z. B. einem Waferprober, auf dem ein Wafer mit zu testenden opto-elektronischen Chips fixiert ist, und einer Testapparatur, zur Generierung und Auswertung von optischen und elektrischen Signalen angeordnet. Das Kontaktierungsmodul stellt die signaltechnische Verbindung zwischen den individuellen, optischen und elektrischen Schnittstellen eines zu testenden opto-elektronischen Chips und den gerätetechnisch vorgegebenen optischen und elektrischen Schnittstellen der Testapparatur her. Bei den Schnittstellen handelt es sich jeweils um elektrische oder optische Ein- und Ausgänge, aus denen bzw. in die die elektrischen oder optischen Signale ein- bzw. ausgekoppelt werden und über elektrische oder optische Signalleitungen zu dem zu testenden opto-elektronischen Chip hin- bzw. weggeleitet werden.

Die elektrischen Schnittstellen am Kontaktierungsmodul 1 sind jeweils durch die Nadelspitzen von Kontaktierungsnadeln gebildet, die zur Übertragung der elektrischen Signale jeweils mit einer elektrischen Schnittstelle des zu testenden opto-elektronischen Chips, die jeweils durch ein elektrisches Kontaktplättchen gebildet sind, mechanisch in Kontakt stehen. Die für eine sichere elektrische Kontaktierung erforderlichen Toleranzgrenzen sind, wie in der Beschreibung des Standes der Technik ausführlich dargelegt, im Vergleich zu für die optische Kontaktierung benötigten Toleranzen groß.

Auch ist aus der vorgenannten WO 2019/029765 A1 bekannt, dass das Kontaktierungsmodul ein Elektronikmodul, an dem die elektrischen Schnittstellen angeordnet sind und ein Optikmodul, an dem die optischen Schnittstellen angeordnet sind enthält. Das Optikmodul ist über mechanische Schnittstellen definiert am Elektronikmodul befestigt, womit die Anordnung von elektrischen Schnittstellen zu der Anordnung von optischen Schnittstellen eine definierte Relativlage aufweist.

Der Vorteil im Vergleich zu einem monolithischen Kontaktierungsmodul liegt insbesondere darin, dass die elektrischen Signalleitungen und die optischen Signalleitungen voneinander unabhängig durch unterschiedliche Herstellungsverfahren und auch in bzw. auf Substraten aus unterschiedlichem Material hergestellt werden können. Damit alle Schnittstellen, egal ob optisch oder elektrisch, eine gemeinsame Anordnung bilden, die relativ zu dem zu testenden opto-elektronische Chip justiert werden kann, ist er Optikblock zu dem Elektronikblock justiert fest angeordnet.

In einer vorteilhaften Ausführung des Kontaktierungsmoduls ist der Optikblock vorteilhaft in seiner Dimension und Geometrie, einschließlich Durchbrüchen bzw. Öffnungen, so ausgeführt, dass alle am Elektronikmodul vorhandenen Kontaktierungsnadeln an dem Optikblock vorbei, um ihn herum und / oder gegebenenfalls durch in ihm ausgebildete Öffnungen hindurch mit dem Chip 2 in Kontakt stehen können. Das ermöglicht die Integration aller optischen Schnittstellen in einem monolithischen Optikblock.

In einem Ausführungsbeispiel eines in der vorgenannten WO 2019/029765 A1 Kontaktierungsmoduls entspricht das Elektronikmodul in seiner technischen Ausführung einem herkömmlichen Kontaktierungsmodul für rein elektronische Chips. Es enthält eine Leiterplatte, eine Anordnung von Kontaktierungsnadeln, hier beispielhaft als Cantilever-Nadeln ausgeführt, und Trägerplatte an der sich die mechanischen Schnittstellen zur Testapparatur befinden. Die elektrische Kontaktierung erfolgt über das Elektronikmodul durch physikalischen Kontakt der Kontaktierungsnadeln mit den elektrischen Kontaktplättchen des Chips.

Das Optikmodul besteht aus einem Optikblock mit optischen Signalleitungen, jeweils in Form von Wellenleitern und einem pro Wellenleiter vorgeordneten integrierten Spiegel, einem V-Nuten aufweisenden Faserhalter, sowie Glasfasern und Einzel-Fasersteckern bzw. einem Multi-Faserstecker. Die Wellenleiter sind mit einem Laserdirektschreibverfahren und die Spiegel mit einem laserunterstützten Ätzverfahren hergestellt. Folglich werden die Wellenleiter infolge des Eintrages von Laserenergie durch örtlich begrenztes modifiziertes Substratmaterial gebildet, welches sich insbesondere durch eine lokale Brechzahlmodifikation gegenüber der Brechzahl des Substratmaterials auszeichnet. Die Spiegel werden durch Grenzflächen von geätzten Ausnehmungen in dem Substratmaterial gebildet. Das Substratmaterial des Optikblocks ist Glas, bevorzugt Borofloatglas, und weist eine Dicke im Bereich von einigen 100 µm bis einigen Millimetern, bevorzugt 0,5 - 1 mm, auf. Die optische Kontaktierung erfolgt ohne direkten Kontakt mit dem Chip über einen Abstand zwischen dem Chip und dem Kontaktierungsmodul. Mit dem verwendete Verfahren zur Herstellung der Spiegel und der Wellenleiter, können insbesondere die durch die optischen Schnittstellen hochgenau zueinander und zu einer mechanischen Schnittstelle am Optikblock gefertigt werden. Darüber hinaus ist eine freie Positionierung der Spiegel und der Wellenleiter innerhalb des Substratmaterial möglich.

Bevorzugt ist das Optikmodul mit dem Elektronikmodul verbunden indem es an einer im Elektronikmodul vorhandene Trägerplatte z. B. über drei Fixierpunkte angeklebt ist. Bei der Fertigung des Elektronikmoduls, z. B. mit Cantilever-Nadeln als Kontaktierungsnadeln, wird die Z-Höhe der Nadeln i.d.R. auf die Einspannpunkte des Kontaktierungsmoduls mit festem Bezug zur Waferplattform referenziert. Bei einem Metallrahmen als Trägerplatte liegen diese Referenzpunkte auf dem Metallrahmen, in den die Fixierpunkte für das Optikmodul mit hoher Präzision integriert werden. Somit kann das Optikmodul durch positionsgenaues Kleben auf die Fixierpunkte in Z-Richtung exakt planparallel und genau in Bezug auf die Referenzebene der Spitzen der Kontaktierungsnadeln montiert werden. Eine planparallele Montage des Optikmoduls zum Elektronikmodul verhindert zudem, dass das Optikmodul mit dem Chip im Betrieb, während der Kontaktierung, aufgrund des geringen Arbeitsabstandes kollidiert.

Alternativ zur Befestigung an der Trägerplatte kann der Optikblock auch direkt an der Leiterplatte befestigt sein.

In der vorgenannten WO 2019/029765 A1 ist lediglich offenbart und nahegelegt mechanische Schnittstellen zwischen dem Optikblock und dem Elektronikmodul mittelbar über Klebstoff miteinander zu verbinden. Genauere Hinweise hierzu werden nicht gemacht, weshalb nahegelegt ist, dass hier zwischen plan ausgeführten mechanischen Schnittstellen Klebstoff einbracht wird.

Die Aufgabe der Erfindung besteht darin, ein Kontaktierungsmodul mit einer neuen, kostengünstigen Gestaltung der mechanischen Schnittstellen zwischen dem Optikblock und dem Elektronikmodul oder dem Optikblock und einer mit dem Elektronikblock verbundenen Montageplatte zu finden, mit der der Optikblock in allen 6 Freiheitsgraden zum Elektronikmodul in eine Justierlage frei positionierbar und anschließend exakt in dieser Justierlage permanent fixierbar ist.

Es ist auch eine Aufgabe der Erfindung ein Verfahren zur Montage eines zu einem Elektronikmodul oder einer mit dem Elektronikblock verbundenen Montageplatte in allen 6 Freiheitsgraden justierbaren Optikblocks zu finden, mit dem der Optikblock in einer einjustierten Lage hochgenau und einfach fixierbar ist.

Die Aufgabe für ein Kontaktierungsmodul wird für einen Kontaktierungsmodul mit einem Optikmodul, enthaltend einen Optikblock aus Glas, der in einer optischen Schnittstellenebene eine Anordnung von optischen Schnittstellen aufweist und einem Elektronikmodul, enthaltend eine Trägerplatte, eine Leiterplatte und einen Nadelträger mit einer Anordnung von Kontaktierungsnadeln mit Nadelspitzen, die in einer elektrischen Schnittstellenebene eine Anordnung von elektrischen Schnittstellen bilden, wobei das Optikmodul und das so zueinander angeordnet sind, dass die Anordnung von optischen Schnittstellen und die Anordnung von elektrischen Schnittstellen eine definierte Justierlage bezogen auf alle sechs Freiheitsgrade eines kartesischen Koordinatensystems zueinander aufweisen, gelöst. Es ist erfindungswesentlich, dass gemäß einer ersten Alternative der Optikblock mit der Trägerplatte über wenigstens drei Zylinderstifte permanent verbunden ist oder gemäß einer zweiten Alternative das Optikmodul eine Montageplatte aufweist, mit der der Optikblock über wenigstens drei Zylinderstifte permanent verbunden ist. Die Zylinderstifte liegen jeweils mit einer ersten Stirnseite über Klebstoff am Optikblock an. In der Trägerplatte bzw. in der Montageplatte sind zueinander parallel angeordnete Durchgangsbohrungen vorhanden, in denen die Zylinderstifte jeweils über Klebstoff mit der Trägerplatte bzw. der Montageplatte verbunden sind.

Vorteilhafte Ausführungen sind in den rückbezogenen Unteransprüchen 2 bis 6 angegeben.

Die Aufgabe für ein Verfahren wird mit einem Verfahren zur Montage eines Kontaktierungsmoduls, mit einem Optikmodul, enthaltend einen Optikblock aus Glas, der in einer optischen Schnittstellenebene eine Anordnung von optischen Schnittstellen aufweist, und einem Elektronikmodul, enthaltend eine Trägerplatte, eine Leiterplatte und einen Nadelträger mit einer Anordnung von Kontaktierungsnadeln mit Nadelspitzen die in einer elektrischen Schnittstellenebene eine Anordnung von elektrischen Schnittstellen bilden, wobei das Optikmodul und das Elektronikmodul so zueinander angeordnet sind, dass die Anordnung von optischen Schnittstellen und die Anordnung von elektrischen Schnittstellen eine definierte Justierlage zueinander aufweisen gelöst.

Gemäß einer ersten Alternative wird zuerst die Anordnung von optischen Schnittstellen zu der Anordnung von elektrischen Schnittstellen justiert wird und dann der Optikblock mit der Trägerplatte permanent über eine erfindungsgemäße Klebeverbindung verbunden.

Gemäß einer zweiten Alternative wird erst die im Optikmodul enthaltene Montageplatte mit der Trägerplatte über eine lösbare Verbindung in einer wiederholt herstellbaren Relativlage verbunden, anschließend die Anordnung von optischen Schnittstellen zu der Anordnung von elektrischen Schnittstellen justiert und dann der Optikblock mit der Montageplatte permanent über eine erfindungsgemäße Klebeverbindung verbunden.

Es ist erfindungswesentlich, dass das Herstellen der Klebeverbindung für beide genannten Alternativen erfolgt, indem in die Trägerplatte bzw. die Montageplatte mindestens drei zueinander parallele Durchgangsbohrungen eingebracht werden und in die mindestens drei Zylinderstifte jeweils durch eine der Durchgangsbohrungen geführt werden, bis sie jeweils zur Anlage an den Optikblock kommen. Zuvor wird auf einer dem Optikblock jeweils zugewandten erste Stirnseite der Zylinderstifte Klebstoff aufgetragen, sodass sie mit dem Optikblock verkleben. Mit der Trägerplatte bzw. der Montageplatte werden die Zylinderstifte verklebt entweder während oder nach dem Führen durch die Durchgangsbohrungen.

Die Erfindung wird nachfolgend anhand von Ausführungsbeispielen und Zeichnungen näher erläutert. Hierzu zeigen:
- Fig. 1a und 1b: ein Kontaktierungsmodul gemäß einer ersten Alternative bei der der Optikblock des Optikmoduls über eine Klebeverbindung mit der Trägerplatte des Elektronikmoduls verbunden ist, in einer Draufsicht und einem Schnittbild,
- Fig. 2a und 2b: ein Kontaktierungsmodul gemäß einer zweiten Alternative bei der der Optikblock an einer Montageplatte des Optikmoduls über eine Klebeverbindung verbunden ist, in einer Draufsicht und einem Schnittbild,
- Fig. 3a: eine erste Ausführung einer erfindungsgemäßen Klebeverbindung,
- Fig. 3b: eine zweite Ausführung einer erfindungsgemäßen Klebeverbindung,
- Fig. 4a und 4b: ein Kontaktierungsmodul gemäß der zweiten Alternative mit einer ersten Ausführung der lösbaren Verbindung

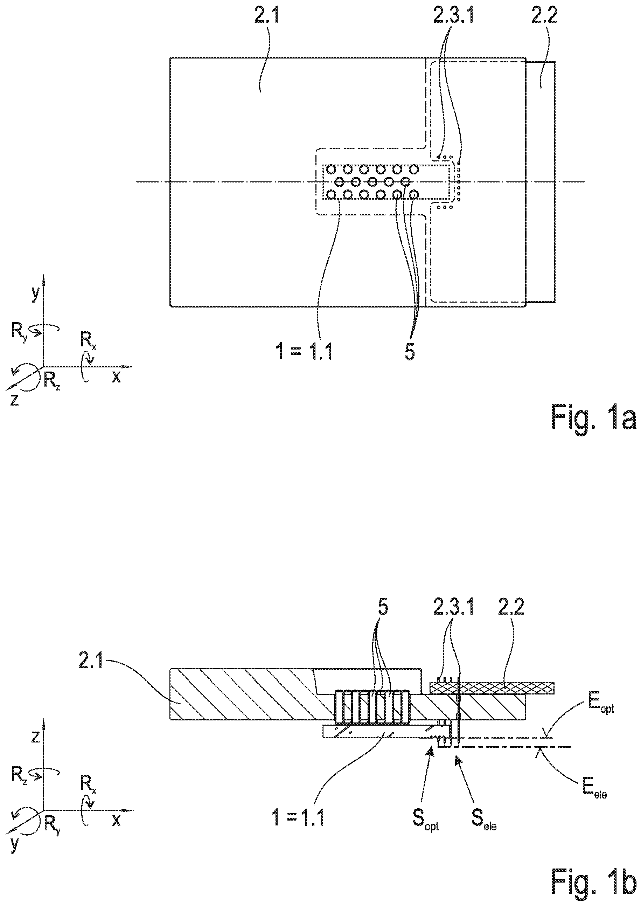

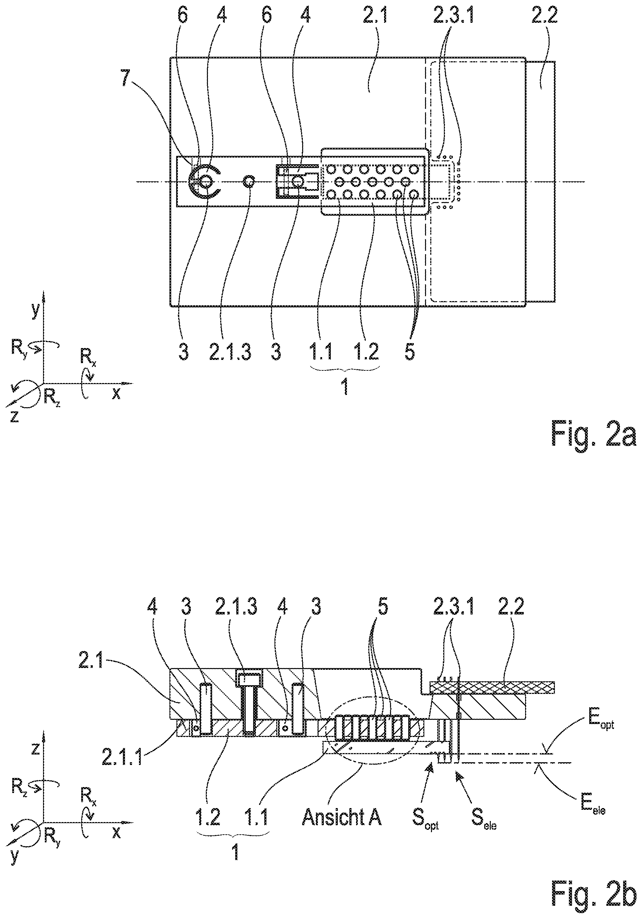

Ein erfindungsgemäßes Kontaktierungsmodul, wie in den **Fig. 1a und 1b** gezeigt, weist ein Optikmodul 1, enthaltend einen Optikblock 1.1 aus Glas, der in einer optischen Schnittstellenebene Eₒₚₜ eine Anordnung von optischen Schnittstellen Sₒₚₜ aufweist und einem Elektronikmodul 2, enthaltend eine Trägerplatte 2.1, eine Leiterplatte 2.2 und einen Nadelträger 2.3 mit einer Anordnung von Kontaktierungsnadeln 2.3.1 mit Nadelspitzen, die in einer elektrischen Schnittstellenebene Eₑₗₑ eine Anordnung von elektrischen Schnittstellen Sₑₗₑ bilden, auf. Die Trägerplatte 2.1 und der Nadelträger 2.3 sind fest miteinander verbunden oder stellen eine monolithische Einheit dar. Das Optikmodul 1 und das Elektronikmodul 2 sind so zueinander angeordnet sind, dass die Anordnung von optischen Schnittstellen Sₒₚₜ und die Anordnung von elektrischen Schnittstellen Sₑₗₑ eine definierte Justierlage bezogen auf alle sechs Freiheitsgrade eines kartesischen Koordinatensystems zueinander aufweisen. Der Optikblock 1.1 ist über eine Klebeverbindung in einer Justierlage fixiert. Dabei kann, gemäß einer ersten Alternative für einen erfindungsgemäßen Kontaktierungsmodul die Justierlage unmittelbar zwischen dem Optikblock 1.1 und dem Elektronikmodul 2, für das die Trägerplatte 2.1 die mechanische Basis bildet, über eine erfindungsgemäße Klebeverbindung fixiert sein, siehe **Fig. 1a und 1b** oder sie kann, gemäß einer zweiten Alternative mittelbar zwischen dem Optikblock 1.1 und einer vom Optikmodul 1 gegebenenfalls umfassten Montageplatte 1.2 über eine erfindungsgemäße Klebeverbindung fixiert sein, die mit dem Elektronikmodul 2, genauer mit der Trägerplatte 2.1, über eine reproduzierbare, lösbare Verbindung verbunden ist, siehe **Fig. 2a und 2b****.**

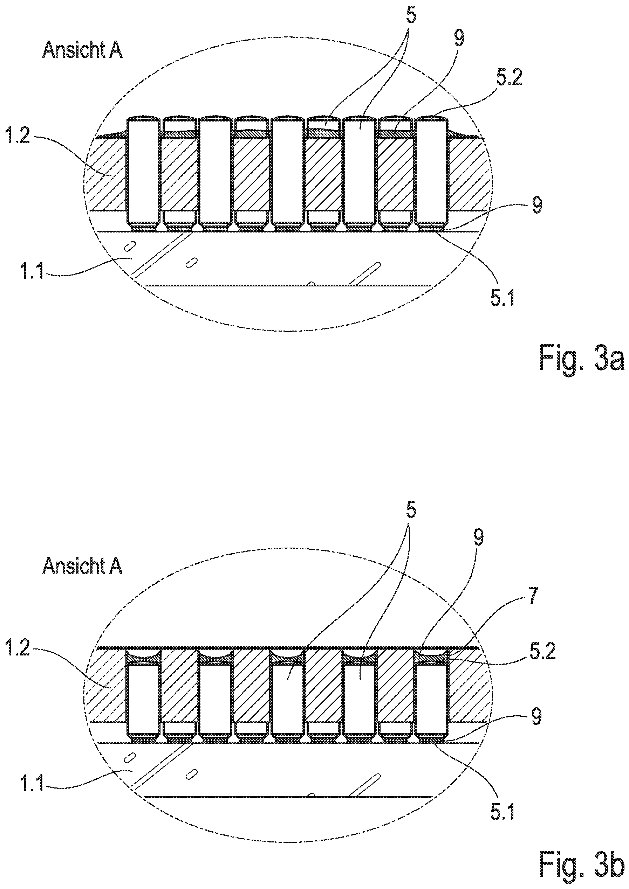

Es ist erfindungswesentlich, dass die Klebeverbindung zwischen dem Optikblock 1.1 und der Montageplatte 1.2 bzw. dem Optikblock 1.1 und der Trägerplatte 2.1 mittelbar über wenigstens drei Zylinderstifte 5 hergestellt ist. Wie in den **Fig. 3a und 3b** besser erkennbar, liegen die Zylinderstifte 5 jeweils mit einer ersten Stirnseite 5.1 über Klebstoff 9 am Optikblock 1.1 an. In der Trägerplatte 2.1 bzw. der Montageplatte 1.2 sind Durchgangsbohrungen 7 vorhanden, in denen die Zylinderstifte 5 jeweils über Klebstoff 9 mit der Trägerplatte 2.1 bzw. der Montageplatte 1.2 fixiert sind.

Dabei sind die Zylinderstifte 5 und die Durchgangsbohrungen 7 in einer Ausführung so aufeinander abgestimmt dimensioniert, dass eine jeweils zweite Stirnfläche 5.2 über die Durchgangsbohrungen 7 hinausragt, womit diese während der Montage, bis zur Anlage an den Optikblock 1.1, gehalten werden können. Der Klebstoff 9 ist in diesem Fall an der jeweils hinausragenden Umfangsfläche der Zylinderstifte 5 aufgetragen, siehe **Fig. 3a****.**

In einer anderen Ausführung, gezeigt in **Fig. 3b****,** ist jeweils die zweite Stirnfläche 5.2 der Zylinderstifte 5 in einer der Durchgangsbohrungen 7 inne liegend angeordnet und ein darüber verbleibendes freies Volumen in der Durchgangsbohrung 7 ist mit Klebstoff 9 verfüllt.

In dem Fall in dem der Optikblock 1.1 erfindungsgemäß mit einer Montageplatte 1.2 verklebt ist, steht die Montageplatte 1.2 vorteilhaft über eine wiederholt lösbare Verbindung mit der Trägerplatte 2.1 in Verbindung, wobei über die lösbare Verbindung eine wiederholte Herstellung der Justierlage der Anordnung der optischen Schnittstellen Sₒₚₜ zu der Anordnung der elektrischen Schnittstellen Sₑₗₑ gewährleistet ist.

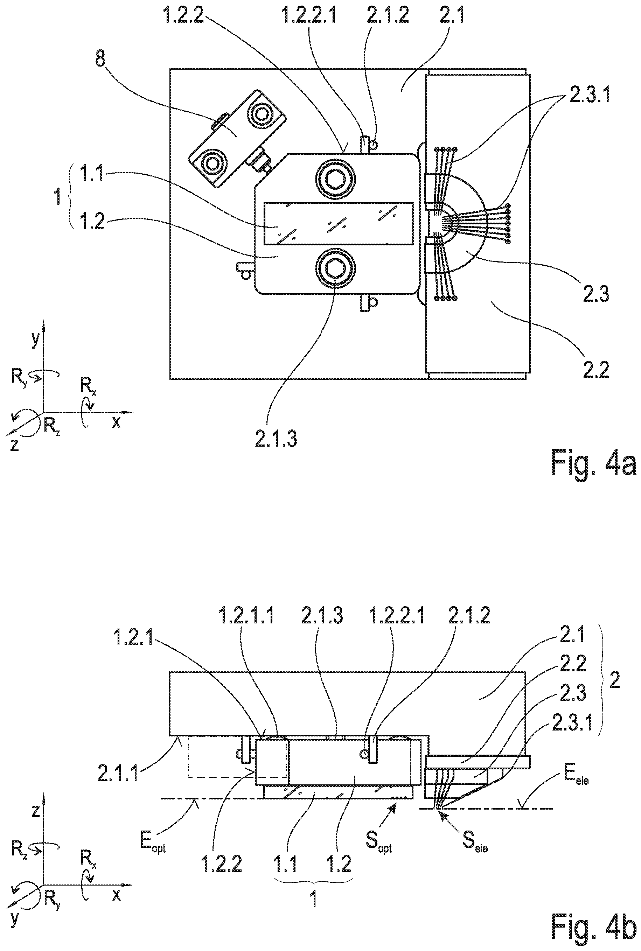

Eine erste Ausführung für die lösbare Verbindung ist in **Fig. 4a und 4b** gezeigt, wobei hier auf die Darstellung einer erfindungsgemäßen Klebeverbindung verzichtet wurde. An einer Stirnseite der Montageplatte 1.2.1 sind hier drei eine Montageebene definierende Erhebungen 1.2.1.1 vorhanden, die an einer Montagefläche 2.1.1 der Trägerplatte 2.1 anliegen, womit die Relativlage der Montageplatte 1.2 in einer z-Richtung, um eine x- Richtung und um eine y-Richtung eines kartesischen Koordinatensystems zur Trägerplatte 2.1 festgelegt ist. Am Umfang der Montageplatte 1.2.2 sind drei, parallel zur Montageebene ausgerichtete Passstifte 2.1.2 vorhanden. Zwei davon sind senkrecht zueinander ausgerichtet und liegen an jeweils einem an der Trägerplatte 2.1 vorhanden Anschlagstift 1.2.2.1 an. Damit wird die Relativlage der Montageplatte1.2. in der x - Richtung und in der y-Richtung zur Trägerplatte 2.1 festgelegt. Der dritte der Passstifte 2.1.2 liegt an einem weiteren an der Trägerplatte 2.1 vorhanden Anschlagstift 1.2.2.1 an, womit die Relativlage der Montageplatte 1.2 um die z-Richtung zur Trägerplatte 2.1 festgelegt ist. Auch bei wiederholter Montage der Montageplatte 1.2 an der Trägerplatte 2.1, nimmt die Montageplatte 1.2 die gleiche Relativlage zur Trägerplatte 2.1 ein. Zum Anlegen der Anschlagstifte 1.2.2.1 an die Passstifte 2.1.2 kann z.B. auf die Trägerplatte 2.1 temporär eine Andruckeinheit 8 aufgesetzt werden. Zur Fixierung der Relativlage ist die Montageplatte 1.2 über wenigstens eine Schraubverbindung 2.1.3 mit der Trägerplatte 2.1 verbunden.

Eine zweite Ausführung für die lösbare Verbindung ist den **Fig. 2a und 2b** zu entnehmen.

Auch hier ist die Relativlage der Montageplatte 1.2 in x-, in y- und um die z-Richtung zur Trägerplatte 2.1 analog der ersten Ausführung über eine Dreipunktauflage bestimmt. Im Unterschied zur ersten Ausführung weist die Montageplatte 1.2 zwei die Montageplatte 1.2 durchdringende Biegestrukturen 4 auf, die z.B. durch Elektroerosion herausgearbeitet wurden. An der Trägerplatte 2.1 sind zwei Klemmstifte 3 senkrecht zur Montagefläche 2.1.1 ausgerichtet, fest mit der Trägerplatte 2.1 verbunden, vorhanden. Sie können unmittelbar oder mittelbar mit der Trägerplatte verbunden sein, z.B. an dem Nadelträger 2.3, der vorteilhaft aus Keramik ist. Zur lösbaren Verbindung der Montageplatte 1.2 an der Trägerplatte 2.1 sind die beiden Klemmstifte 3 jeweils in einer der Biegestrukturen 4 geklemmt. Dabei ist in der ersten der zwei Biegestrukturen 4 der erste der beiden Klemmstifte 3 über deren Mantelfläche umfänglich geklemmt, womit die Relativlage der Montageplatte 1.2 in der x-Richtung und der y-Richtung zur Trägerplatte 2.1 festlegt ist. Vorteilhaft weist die erste der zwei Biegestrukturen 4 die Form einer Rohrschelle auf. In der zweiten der zwei Biegestrukturen 4 ist der zweite der beiden Klemmstifte 3 über dessen Mantelfläche tangential geklemmt, womit die Relativlage der Montageplatte 1.2 um die z-Richtung zur Trägerplatte 2.1 festlegt ist. Zur Klemmung der Biegestrukturen 4 auf jeweils einem der Klemmstifte 3 können diese so dimensioniert sein, dass sie im spannungsfreien Zustand eine Öffnung aufweisen, die kleiner als der Querschnitt der Klemmstifte 3 ist, sodass sie vor oder mit dem Einführen der Klemmstifte 3 gespannt werden und den Klemmstift 3 klemmen. Vorteilhaft sind die Biegestrukturen 4 so dimensioniert, dass sie jeweils eine Öffnung aufweisen, die größer als der Querschnitt der Klemmstifte 3 ist. Erst nach Einführen der Klemmstifte 3 werden die Biegestrukturen 4 gespannt, um die Klemmstifte 3 zu klemmen. Das kann vorteilhaft, wie gezeigt, über einen Gewindestift 6 erfolgen. Vorteilhaft ist zur Sicherung der fixierten Relativlage die Montageplatte 1.2 über wenigstens eine Schraubverbindung 2.1.3 mit der Trägerplatte 2.1 verbunden.

Nachfolgend wird ein erfindungsgemäßes Verfahren zur Montage eines erfindungsgemäßen Kontaktierungsmoduls näher erläutert. Gleich dem Stand der Technik sind am Ende der Justage und Montage das Optikmodul 1 und das Elektronikmodul 2 so zueinander angeordnet, dass die Anordnung von optischen Schnittstellen Sₒₚ und die Anordnung von elektrischen Schnittstellen Sₑₗₑ eine definierte Justierlage in alle 6 Freiheitsgraden zueinander aufweisen.

Mit einem erfindungsgemäßen Verfahren wird ein Kontaktierungsmodul, bestehend aus einem Optikmodul 1 und einem Elektronikmodul 2 montiert. Das Optikmodul 1 enthält einen Optikblock 1.1 aus Glas, der in einer optischen Schnittstellenebene Eₒₚₜ eine Anordnung von optischen Schnittstellen Sₒₚₜ aufweist. Das Elektronikmodul 2, enthält eine Trägerplatte 2.1, eine Leiterplatte 2.2 und einen Nadelträger 2.3 mit einer Anordnung von Kontaktierungsnadeln 2.3.1, mit Nadelspitzen die in einer elektrischen Schnittstellenebene Eₒₚₜ eine Anordnung von elektrischen Schnittstellen Sₑₗₑ bilden. Das Optikmodul 1 und das Elektronikmodul 2 werden so zueinander angeordnet, dass die Anordnung von optischen Schnittstellen Sₒₚₜ und die Anordnung von elektrischen Schnittstellen Sₑₗₑ eine definierte Justierlage zueinander aufweisen.

Das Verfahren kann alternativ angewendet werden, entweder in einer ersten Alternative zur Montage eines vorangehend beschriebenen Kontaktierungsmoduls, bei dem das Optikmodul 1 fest mit dem Elektronikmodul 2 über eine Klebeverbindung verbunden wird, oder in einer zweiten Alternative zur Montage eines vorangehend beschriebenen Kontaktierungsmoduls, bei dem das Optikmodul 1 wiederholt lösbar mit dem Elektronikmodul 2 verbunden ist. Im Falle der zweiten Alternative weist das Optikmodul 1 zusätzlich eine Montageplatte 1.2 auf. Auf der Montageplatte 1.2 ist der Optikblock 1.1 fest mit dieser über eine Klebeverbindung verbunden angeordnet und die Montageplatte 1.2, und somit das Optikmodul 1, ist lösbar mit dem Elektronikmodul 2 verbunden.

Im Falle der ersten Alternative wird die Anordnung von optischen Schnittstellen Sₒₚₜ zu der Anordnung von elektrischen Schnittstellen Sₑₗₑ justiert und dann der Optikblock 1.1 mit der Trägerplatte 2.1 permanent über eine Klebeverbindung fest verbunden.

Im Falle der zweiten Alternative wird zuerst die Montageplatte 1.2 des Optikmoduls 1 mit der Trägerplatte 2.1 des Elektronikmoduls 2 über eine lösbare Verbindung in einer wiederholt herstellbaren Relativlage verbunden. Anschließend wird die Anordnung von optischen Schnittstellen Sₒₚₜ zu der Anordnung von elektrischen Schnittstellen Sₑₗₑ justiert und dann der Optikblock 1.1 wird mit der Montageplatte 1.2 permanent über eine Klebeverbindung verbunden.

Die Ausführung der Klebeverbindung ist erfindungswesentlich.

Um eine erfindungsgemäße Klebeverbindung herzustellen werden zuvor in die Trägerplatte 2.1 bzw. die Montageplatte 1.2 mindestens drei zueinander parallele Durchgangslöcher 7 eingebracht. Im Falle von genau drei Durchgangslöchern 7 sind diese ein Dreieck bildend zueinander angeordnet. Die Durchgangslöcher 7 dienen der späteren Aufnahme von Zylinderstiften 5 über die die Klebeverbindung als eine mittelbare Klebeverbindung hergestellt wird.

Bevor die Klebeverbindung zwischen dem Optikblock 1.1 und der Trägerplatte 2.1 bzw. der Montageplatte 1.2 hergestellt wird, wird der Optikblock 1.1 so ausgerichtet, dass die die Anordnung von optischen Schnittstellen Sₒₚₜ zu der Anordnung von elektrischen Schnittstellen Sₑₗₑ justiert ist. Hierbei entsteht eine Relativlage des Optikblockes 1.1 zu der Trägerplatte 2.1 bzw. der Montageplatte 1.2, die durch die Klebeverbindung in allen 6 Freiheitsgraden fixiert wird.

Mindestens drei Zylinderstifte 5 werden jeweils durch eine der Durchgangsbohrungen 7 geführt, bis sie jeweils zur Anlage an den Optikblock 1.1 kommen, wobei zuvor auf einer dem Optikblock 1.1 jeweils zugewandten erste Stirnseite 5.1 der Zylinderstifte 5 Klebstoff 9 aufgetragen wurde, womit die Zylinderstifte 5 mit dem Optikblock 1.1 verklebt werden. Mit der Trägerplatte 2.1 bzw. mit der Montageplatte 1.2 werden die Zylinderstifte 5 entweder während oder nach dem Führen durch die Durchgangsbohrungen 7 verklebt.

Um die Zylinderstifte 5 beim Führen durch die Durchgangsbohrungen 7 zu verkleben, wird zuvor entweder auf deren Umfangsfläche, der zweiten Stirnseite 5.2 zugewandt, oder in die Durchgangsbohrungen 7 Klebstoff 9 aufgetragen.

Eine definierte Klebefläche für die Zylinderstifte 5 erhält man in dem vorteilhaft die Zylinderstifte 5 und die Durchgangsbohrungen 7 so aufeinander abgestimmt dimensioniert werden, dass die zweite Stirnfläche 5.1 innerhalb der Durchgangsbohrung 7 liegt. Das verbleibende freie Volumen in der Durchgangsbohrung 7 wird dann mit Klebstoff 9 verfüllt.

Sind der Optikblock 1.1 und die Trägerplatte 2.1 bzw. die Montageplatte 1.2 in der einjustierten Relativlage zueinander parallel ausgerichtet, sind alle Zylinderstifte 5 gleichermaßen tief in den Durchgangslöchern 7 eingeklebt. Hieran ändert sich nichts für Relativlagen, die sich in der x-Richtung, in der y-Richtung, in der z-Richtung oder um die z-Richtung unterscheiden. Eine Verkippung um die x-Richtung oder um die y-Richtung wird ausgeglichen, indem die Zylinderstifte 5 mehr oder weniger tief in den Durchgangslöchern ageordnet an dem Optikblock angelegt sind. Im Unterschied zu vielen aus dem Stand der Technik bekannten Klebeverbindungen muss eine Verkippung nicht über die Menge des Klebstoffes 9 ausgeglichen werden. Eine gleiche Klebstoffmenge an allen Stellen an denen die Verbindung entsteht hat den Vorteil, dass das Verhalten des Klebstoffes 9, z.B. ein Schrumpfen beim Verfestigen, überall gleich ist, womit die einjustierte Relativlage hochgenau fixiert wird.

### Bezugszeichenliste

- 1: Optikmodul
- 1.1: Optikblock
- 1.2: Montageplatte
- 1.2.1: Stirnseite der Montageplatte
- 1.2.1.1: Erhebung
- 1.2.2: Umfang der Montageplatte
- 1.2.2.1: Anschlagstift
- 2: Elektronikmodul
- 2.1: Trägerplatte
- 2.1.1: Montagefläche
- 2.1.2: Passstift
- 2.2: Leiterplatte
- 2.3: Nadelträger
- 2.3.1: Kontaktierungsnadel
- 3: Klemmstift
- 4: Biegestruktur
- 5: Zylinderstift
- 5.1: erste Stirnseite des Zylinderstifts
- 5.2: zweite Stirnseite des Zylinderstifts
- 6: Gewindestift
- 7: Durchgangsbohrung
- 8: Andruckeinheit
- 9: Klebstoff

- Sₒₚₜ: optische Schnittstelle
- Sₑₗₑ: elektrische Schnittstelle

- Eₒₚₜ: optische Schnittstellenebene (des Kontaktierungsmoduls)
- Eₑₗₑ: elektrische Schnittstellenebene (des Kontaktierungsmoduls)

## Patentansprüche

1. Kontaktierungsmodul mit einem Optikmodul (1), enthaltend einen Optikblock (1.1) aus Glas, der in einer optischen Schnittstellenebene (Eₒₚₜ) eine Anordnung von optischen Schnittstellen (Sₒₚₜ) aufweist und einem Elektronikmodul (2), enthaltend eine Trägerplatte (2.1), eine Leiterplatte (2.2) und einen Nadelträger (2.3) mit einer Anordnung von Kontaktierungsnadeln (2.3.1) mit Nadelspitzen, die in einer elektrischen Schnittstellenebene (Eₑₗₑ) eine Anordnung von elektrischen Schnittstellen (Sₑₗₑ) bilden, wobei das Optikmodul (1) und das Elektronikmodul (2) so zueinander angeordnet sind, dass die Anordnung von optischen Schnittstellen (Sₒₚₜ) und die Anordnung von elektrischen Schnittstellen (Sₑₗₑ) eine definierte Justierlage bezogen auf alle sechs Freiheitsgrade eines kartesischen Koordinatensystems zueinander aufweisen, **dadurch gekennzeichnet,**
**dass** der Optikblock (1.1) mit der Trägerplatte (2.1) über wenigstens drei Zylinderstifte (5) permanent verbunden ist oder das Optikmodul (1) eine Montageplatte (1.2) aufweist, mit der der Optikblock (1.1) über wenigstens drei Zylinderstifte (5) permanent verbunden ist, wobei die Zylinderstifte (5) jeweils mit einer ersten Stirnseite des Zylinderstifts (5.1) über Klebstoff (9) am Optikblock (1.1) anliegen und in der Trägerplatte (2.1) bzw. der Montageplatte (1.2) zueinander parallel angeordnete Durchgangsbohrungen (7) vorhanden sind, in denen die Zylinderstifte (5) jeweils über Klebstoff (9) mit der Trägerplatte (2.1) bzw. der Montageplatte (1.2) verbunden sind.

2. Kontaktierungsmodul nach Anspruch 1, **dadurch gekennzeichnet,**
**dass** jeweils eine zweite Stirnfläche der Zylinderstifte (5.2) in einer der Durchgangsbohrungen (7) inne liegend angeordnet ist und ein darüber verbliebenes freies Volumen in der Durchgangsbohrung (7) mit Klebstoff (9) verfüllt ist.

3. Kontaktierungsmodul nach Anspruch 1 oder 2, **dadurch gekennzeichnet,**
**dass** die Montageplatte (1.2) über eine wiederholt lösbare Verbindung mit der Trägerplatte (2.1) in Verbindung steht, wobei über die lösbare Verbindung eine wiederholte Herstellung der Justierlage der Anordnung der optischen Schnittstellen (Sₒₚₜ) zu der Anordnung der elektrischen Schnittstellen (Sₑₗₑ) gewährleistet ist.

4. Kontaktierungsmodul nach Anspruch 3, **dadurch gekennzeichnet,**
**dass** an einer Stirnseite der Montageplatte (1.2.1) drei eine Montageebene definierende Erhebungen (1.2.1.1) vorhanden sind, die an einer Montagefläche (2.1.1) der Trägerplatte (2.1) anliegen, womit die Relativlage der Montageplatte (1.2) in einer z-Richtung, um eine x-Richtung und um eine y-Richtung eines kartesischen Koordinatensystems zur Trägerplatte (2.1) festgelegt ist und an einem Umfang der Montageplatte (1.2.2) drei, parallel zur Montageebene ausgerichtete Passstifte (2.1.2) vorhanden sind, von denen zwei senkrecht zueinander ausgerichtet sind und die, an jeweils einem an der Trägerplatte (2.1) vorhanden Anschlagstift (1.2.2.1) anliegen, womit die Relativlage der Montageplatte (1.2) in der x -Richtung und in der y-Richtung zur Trägerplatte (2.1) festgelegt ist, und der dritte der Passstifte (2.1.2) an einem weiteren an der Trägerplatte (2.1) vorhanden Anschlagstift (1.2.2.1) anliegt, womit die Relativlage der Montageplatte (1.2) um die z-Richtung zur Trägerplatte (2.1) festgelegt ist.

5. Kontaktierungsmodul nach Anspruch 3, **dadurch gekennzeichnet,**
**dass** an einer Stirnseite der Montageplatte (1.2.1) drei eine Montageebene definierende Erhebungen (1.2.1.1) vorhanden sind, die an einer Montagefläche (2.1.1) der Trägerplatte (2.1) anliegen, womit die Relativlage der Montageplatte (1.2) in einer z-Richtung, um eine x-Richtung und um eine y-Richtung eines kartesischen Koordinatensystems zur Trägerplatte (2.1) festlegt ist und in der Montageplatte (1.2) zwei die Montageplatte (1.2) durchdringende Biegestrukturen (4) ausgearbeitet sind, wobei in der ersten der zwei Biegestrukturen (4) ein an der Trägerplatte (2.1) angebrachter erster Klemmstift (3) über dessen Mantelfläche umfänglich geklemmt ist, womit die Relativlage der Montageplatte (1.2) in der x-Richtung und in der y-Richtung zur Trägerplatte (2.1) festlegt ist und in der zweiten der Biegestrukturen (4) ein an der Trägerplatte (2.1) angebrachter zweiter Klemmstift (3) über dessen Mantelfläche tangential geklemmt ist, womit die Relativlage der Montageplatte (1.2) um die z-Richtung zur Trägerplatte (2.1) festlegt ist.

6. Kontaktierungsmodul nach Anspruch 5, **dadurch gekennzeichnet,**
**dass** die erste Biegestruktur (4) die Form einer Rohrschelle aufweist, in der der erste Klemmstift (3) selbstzentriert geklemmt ist.

7. Verfahren zur Montage eines Kontaktierungsmoduls, mit einem Optikmodul (1), enthaltend einen Optikblock (1.1) aus Glas, der in einer optischen Schnittstellenebene (Eₒₚₜ) eine Anordnung von optischen Schnittstellen (Sₒₚₜ) aufweist, und einem Elektronikmodul (2), enthaltend eine Trägerplatte (2.1), eine Leiterplatte (2.2) und einen Nadelträger (2.3) mit einer Anordnung von Kontaktierungsnadeln (2.3.1) mit Nadelspitzen die in einer elektrischen Schnittstellenebene (Eₒₚₜ) eine Anordnung von elektrischen Schnittstellen (Sₑₗₑ) bilden, wobei das Optikmodul (1) und das Elektronikmodul (2) so zueinander angeordnet sind, dass die Anordnung von optischen Schnittstellen und die Anordnung von elektrischen Schnittstellen eine definierte Justierlage zueinander aufweisen, **dadurch gekennzeichnet,**
**dass** entweder zuerst die Anordnung von optischen Schnittstellen (Sₒₚₜ) zu der Anordnung von elektrischen Schnittstellen (Sₑₗₑ) justiert wird und dann der Optikblock (1.1) mit der Trägerplatte (2.1) permanent über eine Klebeverbindung verbunden wird
oder eine Montageplatte (1.2) mit der Trägerplatte (2.1) über eine lösbare Verbindung in einer wiederholt herstellbaren Relativlage verbunden wird, anschließend die Anordnung von optischen Schnittstellen (Sₒₚₜ) zu der Anordnung von elektrischen Schnittstellen (Sₑₗₑ) justiert wird und dann der Optikblock (1.1) mit der Montageplatte (1.2) permanent über eine Klebeverbindung verbunden wird,
wobei das Herstellen der Klebeverbindung für beide genannten Alternativen erfolgt, indem in die Trägerplatte (2.1) bzw. die Montageplatte (1.2) mindestens drei zueinander parallele Durchgangsbohrungen (7) eingebracht werden,
mindestens drei Zylinderstifte (5) jeweils durch eine der Durchgangsbohrungen (7) geführt werden, bis sie jeweils zur Anlage an den Optikblock (1.1) kommen, wobei zuvor auf einer dem Optikblock (1.1) jeweils zugewandten erste Stirnseite der Zylinderstifte (5.1) Klebstoff (9) aufgetragen wurde, und die Zylinderstifte (5) entweder während oder nach dem Führen durch die Durchgangsbohrungen (7) verklebt werden.

## Claims

1. A contacting module with an optical module (1), containing an optical block (1.1) made of glass, which has an arrangement of optical interfaces (Sₒₚₜ) in an optical interface plane (Eₒₚₜ), and an electronic module (2), containing a carrier plate (2.1), a printed circuit board (2.2) and a needle carrier (2.3) with an arrangement of contacting needles (2.3.1) with needle tips, which form an arrangement of electrical interfaces (Sₑₗₑ) in an electrical interface plane (Eₑₗₑ), the optical module (1) and the electronic module (2) being arranged relative to one another in such a way that the arrangement of optical interfaces (Sₒₚₜ) and the arrangement of electrical interfaces (Sₑₗₑ) have a defined adjustment position relative to one another with respect to all six degrees of freedom of a Cartesian coordinate system, **characterized in that**
the optical block (1.1) is permanently connected to the carrier plate (2.1) via at least three cylindrical pins (5) or the optical module (1) has a mounting plate (1.2) to which the optical block (1.1) is permanently connected via at least three cylindrical pins (5), wherein the cylindrical pins (5) each contact the optical block (1.1) with a first end face (5.1) of the cylindrical pin via adhesive (9), and in the carrier plate (2.1) or in the mounting plate (1.2), there are through holes (7) arranged parallel to each other, in which the cylindrical pins (5) are each connected to the carrier plate (2.1) or the mounting plate (1.2) via adhesive (9).

2. The contacting module according to claim 1, **characterized in that**
a second end face (5.2) of the cylindrical pins is located internally in one of the through holes (7) in each case, and any free volume remaining above it in the through hole (7) is filled with adhesive (9).

3. The contacting module according to claim 1 or 2, **characterized in that**
the mounting plate (1.2) is connected to the carrier plate (2.1) via a repeatedly detachable connection, said detachable connection ensuring repeated production of the adjustment position of the arrangement of the optical interfaces (Sₒₚₜ) with respect to the arrangement of the electrical interfaces (Sₑₗₑ).

4. The contacting module according to claim 3, **characterized in that**,
on one end face of the mounting plate (1.2.1), three elevations (1.2.1.1) defining a mounting plane are present, which rest against a mounting surface (2.1.1) of the carrier plate (2.1), whereby the relative position of the mounting plate (1.2) in a z-direction, about an x-direction and about a y-direction of a Cartesian coordinate system with respect to the carrier plate (2.1) is fixed, and there are three dowel pins (2.1.2) on a circumference of the mounting plate (1.2.2), which are aligned parallel to the mounting plane and two of which are aligned perpendicular to each other and each rest against a respective stop pin (1.2.2.1) provided on the carrier plate (2.1), which determines the relative position of the mounting plate (1.2) in the x-direction and in the y-direction to the carrier plate (2.1), and the third of the dowel pins (2.1.2) rests against a further stop pin (1.2.2.1) present on the carrier plate (2.1), thus fixing the relative position of the mounting plate (1.2) around the z-direction with respect to the carrier plate (2.1).

5. The contacting module according to claim 3, **characterized in that**,
on one end face of the mounting plate (1.2.1), three elevations (1.2.1.1) defining a mounting plane are present, which rest against a mounting surface (2.1.1) of the carrier plate (2.1), whereby the relative position of the mounting plate (1.2) in a z-direction, about an x-direction and about a y-direction of a Cartesian coordinate system with respect to the carrier plate (2.1) is fixed, and the mounting plate (1.2) has two bending structures (4) penetrating the mounting plate (1.2), wherein in the first of the two bending structures (4), a first clamping pin (3) attached to the carrier plate (2.1) is clamped circumferentially over its lateral surface, thus fixing the relative position of the mounting plate (1.2) in the x-direction and in the y-direction with respect to the carrier plate (2.1), and in the second of the bending structures (4), a second clamping pin (3) attached to the carrier plate (2.1) is clamped tangentially via its lateral surface, thus fixing the relative position of the mounting plate (1.2) around the z-direction with respect to the carrier plate (2.1).

6. The contacting module according to claim 5, **characterized in that**
the first bending structure (4) has the shape of a pipe clamp, in which the first clamping pin (3) is clamped in a self-centered manner.

7. A method for assembly of a contacting module with an optical module (1), containing an optical block (1.1) made of glass, which has an arrangement of optical interfaces (Sₒₚₜ) in an optical interface plane (Eₒₚₜ), and an electronic module (2), containing a carrier plate (2.1), a printed circuit board (2.2) and a needle carrier (2.3) with an arrangement of contacting needles (2.3.1) with needle tips, which form an arrangement of electrical interfaces (Sₑₗₑ) in an electrical interface plane (Eₑₗₑ), the optical module (1) and the electronic module (2) being arranged relative to one another in such a way that the arrangement of optical interfaces and the arrangement of electrical interfaces have a defined adjustment position relative to one another, **characterized in that**
either the arrangement of optical interfaces (Sₒₚₜ) is first adjusted to the arrangement of electrical interfaces (Sₑₗₑ) and then the optical block (1.1) is permanently connected to the carrier plate (2.1) via an adhesive connection,
or a mounting plate (1.2) is connected to the carrier plate (2.1) via a detachable connection in a relative position that can be repeatedly produced, after which the arrangement of optical interfaces (Sₒₚₜ) is adjusted to the arrangement of electrical interfaces (Sₑₗₑ) and then the optical block (1.1) is permanently connected to the carrier plate (1.2) via an adhesive connection,
wherein the adhesive connection for both of the above alternatives is produced by making at least three through holes (7) parallel to each other in the carrier plate (2.1) or the mounting plate (1.2),
at least three cylindrical pins (5) are each guided through one of the through holes (7) until they each come into contact with the optical block (1.1), adhesive (9) having previously been applied to a first end face (5.1) of the cylindrical pins which faces the optical block (1.1) in each case, and the cylindrical pins (5) are bonded either during or after guiding them through the through holes (7).

## Revendications

1. Module de mise en contact avec un module optique (1), contenant un bloc optique (1.1) en verre, qui présente dans un plan d'interface optique (Eₒₚₜ) un ensemble d'interfaces optiques (Sₒₚₜ), et un module électronique (2),
contenant une plaque de support (2.1), une carte de circuit imprimé (2.2) et un support d'aiguilles (2.3) avec un ensemble d'aiguilles de contact (2.3.1) avec des pointes d'aiguille qui forment dans un plan d'interface électrique (Eₑₗₑ) un ensemble d'interfaces électriques (Sₑₗₑ), le module optique (1) et le module électronique (2) étant disposés l'un par rapport à l'autre de telle sorte que l'ensemble d'interfaces optiques (Sₒₚₜ) et l'ensemble d'interfaces électriques (Sₑₗₑ) présentent l'un par rapport à l'autre une position d'ajustement définie par rapport à l'ensemble des six degrés de liberté d'un système de coordonnées cartésiennes, **caractérisé**
**en ce que** le bloc optique (1.1) est relié en permanence à la plaque de support (2.1) par au moins trois goupilles cylindriques (5) ou que le module optique (1) présente une plaque de montage (1.2) à laquelle le bloc optique (1.1) est relié en permanence par au moins trois goupilles cylindriques (5), les goupilles cylindriques (5) s'appliquant chacune par une première face frontale de la goupille cylindrique (5.1) contre le bloc optique (1.1) par l'intermédiaire d'une colle (9) et que dans la plaque de support (2.1) ou la plaque de montage (1.2), respectivement, sont prévus des alésages traversants (7) disposés parallèlement les uns aux autres, dans lesquels les goupilles cylindriques (5) sont reliées à la plaque de support (2.1) ou à la plaque de montage (1.2) par l'intermédiaire d'une colle (9).

2. Module de mise en contact selon la revendication 1, **caractérisé**
**en ce qu'**une deuxième face frontale de chacune des goupilles cylindriques (5.2) est disposée à l'intérieur de l'un des alésages traversants (7) et qu'un volume libre subsistant au-dessus de celle-ci dans l'alésage traversant (7) est rempli de colle (9).

3. Module de mise en contact selon la revendication 1 ou 2, **caractérisé**
**en ce que** la plaque de montage (1.2) est en liaison avec la plaque de support (2.1) par l'intermédiaire d'une liaison amovible de manière répétée, une réalisation répétée de la position d'ajustement de l'ensemble des interfaces optiques (Sₒₚₜ) par rapport à l'ensemble des interfaces électriques (Sₑₗₑ) étant garantie par la liaison amovible.

4. Module de mise en contact selon la revendication 3, **caractérisé**
**en ce que** sur une face frontale de la plaque de montage (1.2.1) sont présentes trois surélévations (1.2.1.1) définissant un plan de montage, qui s'appliquent contre une surface de montage (2.1.1) de la plaque de support (2.1), ce qui fixe la position relative de la plaque de montage (1.2) dans une direction z, autour d'une direction x et autour d'une direction y d'un système de coordonnées cartésiennes par rapport à la plaque de support (2.1) et que sur une périphérie de la plaque de montage (1.2.2) se trouvent trois goupilles d'ajustage (2.1.2), dont deux sont orientées perpendiculairement l'une à l'autre et qui s'appuient chacune sur une goupille de butée (1.2.2.1) présente sur la plaque de support (2.1), ce qui fixe la position relative de la plaque de montage (1.2) dans la direction x et dans la direction y par rapport à la plaque de support (2.1), et la troisième des goupilles d'ajustage (2.1.2) s'appuie sur une autre goupille de butée (1.2.2.1) présente sur la plaque de support (2.1), ce qui fixe la position relative de la plaque de montage (1.2) autour de la direction z par rapport à la plaque de support (2.1).

5. Module de mise en contact selon la revendication 3, **caractérisé**
**en ce que** sur une face frontale de la plaque de montage (1.2.1) sont présentes trois surélévations (1.2.1.1) définissant un plan de montage, qui s'appuient sur une surface de montage (2.1.1) de la plaque de support (2.1), ce qui fixe la position relative de la plaque de montage (1.2) dans une direction z, autour d'une direction x et autour d'une direction y d'un système de coordonnées cartésiennes par rapport à la plaque de support (2.1) et deux structures de flexion (4) traversant la plaque de montage (1.2) sont élaborées dans la plaque de montage (1.2), une première goupille de serrage (3) fixée à la plaque de support (2.1) étant serrée sur la circonférence de sa surface latérale, ce qui fixe la position relative de la plaque de montage (1.2) dans la direction x et dans la direction y par rapport à la plaque de support (2.1) et dans la deuxième des structures de flexion (4), une deuxième goupille de serrage (3) montée sur la plaque de support (2.1) est serrée tangentiellement par sa surface d'enveloppe, ce qui fixe la position relative de la plaque de montage (1.2) autour de la direction z par rapport à la plaque de support (2.1).

6. Module de mise en contact selon la revendication 5, **caractérisé**
**en ce que** la première structure de flexion (4) présente la forme d'un collier de serrage dans lequel la première goupille de serrage (3) est serrée de manière autocentrée.

7. Procédé de montage d'un module de mise en contact, avec un module optique (1), contenant un bloc optique (1.1) en verre, qui présente dans un plan d'interface optique (Eₒₚₜ) un ensemble d'interfaces optiques (Sₒₚₜ), et un module électronique (2), contenant une plaque de support (2.1), une carte de circuit imprimé (2.2) et un support d'aiguilles (2.3) avec un ensemble d'aiguilles de contact (2.3.1) avec des pointes d'aiguille qui forment dans un plan d'interface électrique (Eₑₗₑ) un ensemble d'interfaces électriques (Sₑₗₑ), le module optique (1) et le module électronique (2) étant disposés l'un par rapport à l'autre de telle sorte que l'ensemble d'interfaces optiques et l'ensemble d'interfaces électriques présentent l'un par rapport à l'autre une position d'ajustement définie, **caractérisé**
**en ce que** soit l'ensemble d'interfaces optiques (Sₒₚₜ) est d'abord ajusté par rapport à l'ensemble d'interfaces électriques (Sₑₗₑ) et ensuite le bloc optique (1.1) est relié de manière permanente à la plaque support (2.1) par une liaison adhésive,
soit une plaque de montage (1.2) est reliée à la plaque de support (2.1) par l'intermédiaire d'une liaison amovible dans une position relative pouvant être établie de manière répétée, l'ensemble d'interfaces optiques (Sₒₚₜ) est ensuite ajusté par rapport à l'ensemble d'interfaces électriques (Sₑₗₑ), puis le bloc optique (1.1) est relié de manière permanente à la plaque de montage (1.2) par l'intermédiaire d'une liaison adhésive,
la réalisation de l'assemblage par la liaison adhésive pour les deux alternatives mentionnées s'effectuant en pratiquant dans la plaque de support (2.1) ou la plaque de montage (1.2) au moins trois alésages traversants (7) parallèles entre eux,
au moins trois goupilles cylindriques (5) sont guidées chacune à travers l'un des alésages traversants (7) jusqu'à ce qu'elles viennent chacune en appui sur le bloc optique (1.1), de la colle (9) ayant été appliquée auparavant sur une première face frontale des goupilles cylindriques (5.1) tournée respectivement vers le bloc optique (1.1), et les goupilles cylindriques (5) étant collées soit pendant, soit après le guidage à travers les alésages traversants (7).
